# EUROPEAN PATENT APPLICATION

(11) **EP 3 288 359 A1**
(43) Date of publication of application: **28.02.2018**
(21) Application number: 16782801.1
(22) Date of filing: 20.04.2016
(51) Int. Cl.: H05K 7/20, H01L 23/36

(54) **HEAT DISSIPATION MECHANISM AND DEVICE PROVIDED WITH SAME**

(30) Priority: 24.04.2015 JP 2015089271
(71) Applicant: NEC Corporation, Tokyo 108-8001 (JP)
(72) Inventor: ARAMAKI, Chitoshi, Tokyo 108-8001 (JP); HIROSE, Taro, Tokyo 108-8001 (JP)
(74) Representative: Vossius & Partner Patentanwälte Rechtsanwälte mbB
(86) International application number: PCT/JP2016/002107
(87) International publication number: WO 2016/170777

(57) **Abstract**

Provided is a heat dissipation mechanism that allows for a smaller device while also facilitating disassembly. The heat dissipation mechanism is provided with a heat dissipation element, which releases heat externally. The heat dissipation element and a heating element that generates heat are in thermal contact with each other via a thermal conduction film formed from a thermally conductive material having the ability to flow, and via a low-friction film having a lower friction coefficient than the heat dissipation element or the heating element.

## Description

### [Technical Field]

The present invention relates to a heat dissipation mechanism, and, more particularly, to a heat dissipation mechanism for communication infrastructure devices.

### [Background Art]

In various devices such as electric devices and the like, various heat dissipation mechanisms are used in order to efficiently release heat generated at heat generating components. In a device such as a communication infrastructure device, for example, an outdoor base station device in particular, for which the demand for downsizing is strong, improvement in the heat dissipation mechanism is also expected.

For example, as heat dissipation mechanisms for such devices, there have been used a method in which a heat sink is provided on a heat generating component and a method in which a heat generating component and a heat dissipation element (such as a chassis in which a heat radiating fin is provided) are thermally in contact with each other using a heat dissipation sheet such as a heat conductive silicon sheet or a heat dissipation pad (refer to Patent Literature 1 (PTL1)).

In the method only using a heat sink, a large space is needed in a device because heat which has been generated by a heat generating component is radiated into a space within the device (chassis), and, thus, there is a difficulty in miniaturizing the device. In the method to transfer heat to a heat sink using a heat dissipation sheet and a heat dissipation pad, there is a limitation in the shape of a heat dissipation sheet and a heat dissipation pad, and, therefore, they cannot be used depending on the surface form of a heat generating component or a heat dissipation element, and, further, since a thickness of about several millimeters is needed, a device cannot be miniaturized sufficiently.

In contrast, a method to make a heat generating component and a heat dissipation element thermally in contact with each other using a heat dissipation grease is drawing attention. In this method, since a heat dissipation grease has fluid property, there is no limitation on a shape, and, further, its thickness can be thinned to such a degree that a gap between a heat generating component and a heat dissipation element is filled, thereby achieving downsizing of device.

Patent literature 2 (PTL2) relates to a filling process of a thermally conductive fluid, and it is proposed that a high thermal conductive grease which is a thermally conductive fluid is applied to a heat transfer surface of a heat generating element in a dotted manner, and a cooling body is pressed from the upper side of the heat generating element to spread out the high thermal conductive grease. In PTL2, it is proposed to fill a high thermal conductive grease into the heat transfer surface of a heat generating element by spreading out the high thermal conductive grease in this way.

### [Citation List]

### [Patent Literature]

[PTL1] Japanese Patent Application Laid-Open No. 2012-134501
[PTL2] Japanese Patent Application Laid-Open No. Hei 9-293811

### [Summary of Invention]

### [Technical Problem]

However, a heat dissipation grease has relatively strong fixing strength, and thus, in the method using a heat dissipation grease, there is an issue of sticking between a heat generating component and a heat dissipation structure by the heat dissipation grease and increasing difficulty in disassembling work of device, which is performed at the time of adjustment when assembling the device and at the time of maintenance of the device. For this reason, due to such as bending of the substrate of a heat generating component at the time of disassembling work of device, various parts mounted on the substrate may be damaged.

The present invention has been made in view of the above issue, and its object is to provide a heat dissipation mechanism capable of reducing the difficulty in disassembling work while realizing downsizing of device, and to provide a device including such heat dissipation mechanism.

### [Solution to Problem]

A heat dissipation mechanism by the present invention, includes a heat dissipation element for releasing heat outside, wherein a heat generating element that generates heat and the heat dissipation element are thermally in contact with a heat conductive film composed of a thermally conductive material having fluid property with a low-friction film having a friction coefficient lower than a friction coefficient of the heat dissipation element or the heat generating element therebetween.

In addition, a device by the present invention, includes a heat generating element that generates heat, and the heat dissipation mechanism mentioned above.

### [Advantageous Effect of Invention]

According to the present invention, the difficulty in disassembling work can be reduced while realizing downsizing of device.

### [Brief Description of Drawings]

[Fig. 1] Fig. 1 is an exploded perspective view schematically illustrating a communication infrastructure device of an example embodiment of the present invention.
[Fig. 2] Fig. 2 is a sectional view schematically illustrating a communication infrastructure device of an example embodiment of the present invention.
[Fig. 3] Fig. 3 is a diagram for describing an evaluation method of a peeling load.

### [Description of Embodiments]

Hereinafter, example embodiments of the present invention will be described with reference to drawings. Note that a same reference symbol denotes an element having a same function in the drawings, and description of it may not be repeated.

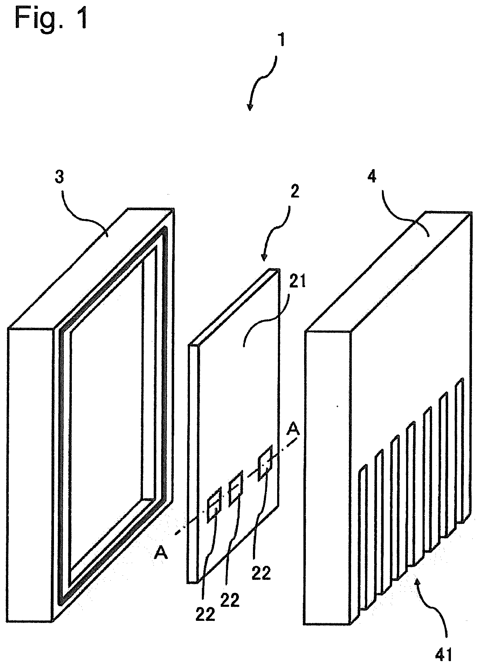

Fig. 1 is an exploded perspective view that schematically illustrates a communication infrastructure device of a first example embodiment of the present invention. A communication infrastructure device 1 illustrated in Fig. 1 includes an inner device 2 and chassis elements 3 and 4. Note that the communication infrastructure device 1 is a device including a heat dissipation mechanism, and, for example, is a communication device such as a wireless base station installed outdoors.

The inner device 2 has a substrate 21 and a heat generating component 22 provided on the substrate 21. The heat generating component 22 is a heat generating element which generates heat. The heat generating component 22 is a central processing unit (CPU) and a battery, for example, but is not limited to these. The number of pieces, a shape and arrangement of the heat generating component 22 is also not limited in particular. In the example of Fig. 1, three pieces of heat generating component 22 are provided on the substrate 21. Alternatively, various components may be provided on the substrate 21 besides the heat generating component 22.

The chassis elements 3 and 4 are the members constituting the chassis of the communication infrastructure device 1, and form an accommodation space for housing the inner device 2 between them by being combined with each other in a facing manner. The chassis element 4 has a heat dissipation structure 41 that releases heat. As a result, the chassis element 4 functions as a heat dissipation element to release heat to the outside. Hereinafter, the chassis element 4 is called a heat dissipation element 4. Note that the heat dissipation structure 41 includes a plurality of heat radiating fins in the example of Fig. 1.

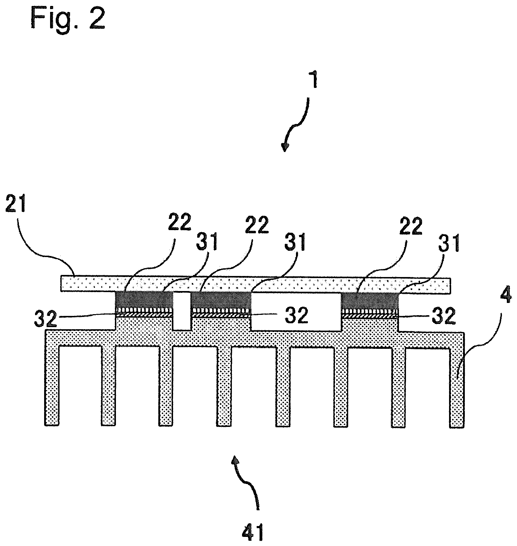

Fig. 2 is a sectional view of the communication infrastructure device 1 taken along line A-A of Fig. 1. Note that, since the chassis element 3 is not related to the present invention directly, it is omitted in Fig. 2.

As illustrated in Fig. 2, in the communication infrastructure device 1, the heat dissipation element 4 and the heat generating component 22 provided on the substrate 21 are thermally in contact with each other with a heat conductive film 32 and a low-friction film 31 therebetween. In the example of Fig. 2, although the heat generating component 22, the low-friction film 31, the heat conductive film 32 and the heat dissipation element 4 are provided in this order, it may alternatively be provided in the order of the heat generating component 22, the heat conductive film 32, the low-friction film 31 and the heat dissipation element 4.

The heat dissipation element 4, the low-friction film 31 and the heat conductive film 32 form a heat dissipation mechanism to release heat generated at the heat generating component 22 to the outside of the communication infrastructure device 1.

The low-friction film 31 has a friction coefficient lower than the friction coefficient of the heat dissipation element 4 or the heat generating component 22. Specifically, the low-friction film 31 has a friction coefficient lower than the friction coefficient of one of the heat dissipation element 4 and the heat generating component 22 that is physically in contact with the low-friction film 31. In this example embodiment, the low-friction film 31 is physically in contact with the heat generating component 22, and thus a film having a friction coefficient lower than the friction coefficient of the heat generating component 22 is used as the low-friction film 31. When the low-friction film 31 is physically in contact with the heat dissipation element 4, a film having a friction coefficients lower than the friction coefficient of the heat dissipation element 4 is used as the low-friction film 31.

The low-friction film 31 is formed using various lubricants such as a fluorine-based lubricant and the like. As a result, the low-friction film 31 can be made thin, and a decrease in thermal conductivity between the heat generating component 22 and the heat dissipation element 4 can be suppressed. Furthermore, formation of an air layer (air bubble) that brings an insulation effect can be reduced, and the heat dissipation effect can be secured.

The lubricant may be a liquid lubricant. However, it is desirable that the lubricant be composed of a dried-film lubricant having an age-hardening property, and it is more desirable that the lubricant be composed of a dried-film lubricant with no oil content. The reason of this is that, when the low-friction film 31 is composed of a dried-film lubricant (dried-film lubricant that does not have oil content, in particular), it is possible in particular to reduce the force required to peel the heat dissipation element 4 from the heat generating component 22, as will be described later. In addition, by using a dried-film lubricant as a lubricant, it is possible to make the low-friction film 31 thin to the thickness of the order of several µm and it is also possible to improve application work when applying the lubricant. Note that it is desirable that the dried-film lubricant have a quick-dry property. When a fluorine-based lubricant is used, alteration of the low-friction film 31 by heat can be suppressed.

The heat conductive film 32 is composed of a heat dissipation grease that is a thermally conductive material having fluid property. For example, the heat dissipation grease is a silicon-based grease. In this example embodiment, a heat dissipation grease has hardenability, and the heat conductive film 32 is formed in a manner that a heat dissipation grease is applied on the heat generating component 22 and, after that, the heat dissipation grease hardens into an elastic body (elastic body with a shape restoration property) of a predetermined hardness. Although the kind of a heat dissipation grease can be selected appropriately according to the kind of heat generating component 22, it is desirable that the heat dissipation grease be a two-component composition. The reason of this is that a heat dissipation grease of a two-component composition has a low decrease in viscosity even in high temperature environment and thus moves little. Note that there is a little aging change in a heat dissipation grease after hardening, and, even if a subtle change occurs to the distance between the heat generating component 22 and the heat dissipation element 4 due to a vibration or impact, a stable heat dissipation mechanism can be realized because the heat dissipation grease also changes following the change.

As it has been described above, according to this example embodiment, the heat generating component 22 and the heat dissipation element 4 are thermally in contact with each other with the heat conductive film 32 composed of a thermally conductive material having fluid property and the low-friction film 31 having a friction coefficient lower than the friction coefficient of the heat generating component 22 or the heat dissipation element 4 therebetween. For this reason, the low-friction film 31 comes to be provided between the heat conductive film 32 and the heat generating component 22 or the heat dissipation element 4, and, thus, the fixing strength of the heat conductive film 32 can be reduced by the low-friction film 31. Accordingly, it becomes possible to suppress sticking of the heat generating component 22 and the heat dissipation element 4 due to the heat conductive film 32 even if a film such as heat dissipation grease having strong fixing strength is used as the heat conductive film 32, and, therefore, the difficulty in disassembling work can be reduced while realizing downsizing of the communication infrastructure device 1.

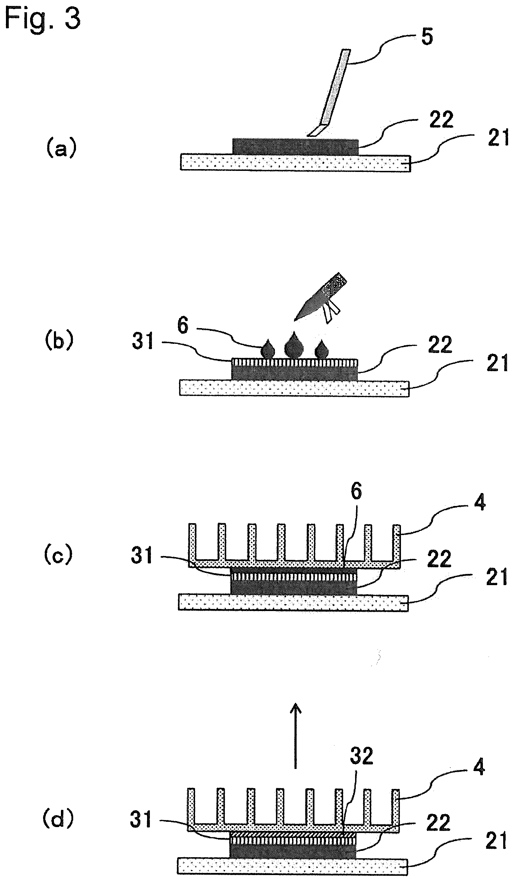

Hereinafter, a peeling load that represents the force required to peel the heat dissipation element 4 and the heat generating component 22 will be evaluated using a specific example of a heat dissipation mechanism. Fig. 3 is a diagram illustrating an evaluation method of a peeling load.

First, as illustrated in Fig. 3(a), lubricant is applied to the top surface of the heat generating component 22 provided on the substrate 21 by a brush 5 to form the low-friction film 31. Next, as illustrated in Fig. 3(b), a heat dissipation grease 6 is applied on the low-friction film 31. Then, as illustrated in Fig. 3(c), the heat dissipation element 4 is attached in such a way that the heat dissipation element 4 is pressed from the upper side of the heat dissipation grease 6. As a result, the heat dissipation grease 6 is spread and adheres tightly with the heat dissipation element 4. After that, when curing time relating to the heat dissipation grease 6 has passed, the heat dissipation grease 6 is hardened, and the heat conductive film 32 is formed. Then, in this state, the heat dissipation element 4 is pulled up in a vertical direction (the direction of the arrow in the figure) as illustrated in Fig. 3(d), and the force of the vertical direction applied to the heat dissipation element 4 at the time the heat dissipation element 4 is peeled off from the heat generating component 22 is evaluated as a peeling load.

Table 1 indicates an evaluation result of a peeling load. Specifically, the table 1 indicates, about respective cases of when the surface material of a heat generating component is resin and when the surface material is a sheet metal, peeling loads when a lubricant which is the material forming the low-friction film 31 is a dried-film lubricant with no oil content, a dried-film lubricant with oil content, a liquid lubricant and when, as a comparison example, there is no low-friction film 31.

**[Table 1]**

| SURFACE MATERIAL AND SIZE OF HEAT GENERATING COMPONENT | WITH NO LUBRICANT | WITH LUBRICANT | | |
|---|---|---|---|---|
| | | DRIED-FILM LUBRICANT (WITH NO OIL CONTENT) | DRIED-FILM LUBRICANT (WITH OIL CONTENT) | LIQUID LUBRICANT |
| RESIN (30mm × 30mm) | 94.3[N] | 48.6[N] | 71.7 [N] | 97.9 [N] |
| SHEET METAL (35mm × 35mm) | 144.4[N] | 106.2 [N] | 130.4[N] | 128.2 [N] |

As illustrated in Table 1, when a lubricant exists, a peeling load is smaller than that of the case when a lubricant does not exist in general. In particular, in the case of dried-film lubricant in which the lubricant does not have oil content, it is clear that the peeling load is very small compared with the case in which a lubricant does not exist.

In the example embodiments described above, the illustrated structures are just examples, and the present invention is not limited to such structures.

For example, although the communication infrastructure device 1 has two chassis elements 3 and 4, and the chassis element 4 that is one of them has a structure that functions as a heat dissipation element, the compositions, the shapes and the like of the communication infrastructure device 1 and the heat dissipation element are not limited to this example. Also, a device having a heat dissipation mechanism is not limited to the communication infrastructure device 1, and it may be a different device.

Alternatively, as a lubricant for forming the low-friction film 31, a lubricant that allows, at the time when the heat dissipation element 4 is being peeled off from the heat generating component 22, the low-friction film 31 to be torn before the force applied to the heat dissipation element 4 reaches the peeling load illustrated in Table 1 may be used.

A part or all of each of the above-mentioned example embodiments can be described as, but not limited to, the following supplementary notes.

### [Supplementary note 1]

A heat dissipation mechanism including
a heat dissipation element for releasing heat outside, wherein
a heat generating element that generates heat and the heat dissipation element are thermally in contact with a heat conductive film composed of a thermally conductive material having fluid property with a low-friction film having a friction coefficient lower than a friction coefficient of the heat dissipation element or the heat generating element therebetween.

### [Supplementary note 2]

The heat dissipation mechanism according to supplementary note 1, wherein the low-friction film is composed of a dried-film lubricant.

### [Supplementary note 3]

The heat dissipation mechanism according to supplementary note 2, wherein the low-friction film does not have oil content.

### [Supplementary note 4]

The heat dissipation mechanism according to any one of supplementary notes 1 to 3, wherein the low-friction film is composed of a fluorine-based lubricant.

### [Supplementary note 5]

The heat dissipation mechanism according to any one of supplementary notes 1 to 4, wherein the thermally conductive material has hardenability.

### [Supplementary note 6]

The heat dissipation mechanism according to supplementary note 5, wherein the thermally conductive material is a two-component composition.

### [Supplementary note 7]

The heat dissipation mechanism according to any one of supplementary notes 1 to 6, wherein the thermally conductive material is a silicon-based grease.

### [Supplementary note 8]

The heat dissipation mechanism according to any one of supplementary notes 1 to 7,
wherein the heat conductive film is physically in contact with the heat generating element, and
wherein the low-friction film is physically in contact with the heat conductive film and the heat dissipation element, and has a friction coefficient lower than a friction coefficient of the heat dissipation element.

### [Supplementary note 9]

The heat dissipation mechanism according to any one of supplementary notes 1 to 7,
wherein the heat conductive film is physically in contact with the heat dissipation element, and
wherein the low-friction film is physically in contact with the heat conductive film and the heat generating element, and has a friction coefficient lower than a friction coefficient of the heat generating element.

### [Supplementary note 10]

A device comprising:
a heat generating element that generates heat; and
a heat dissipation mechanism according to any one of supplementary notes 1 to 9.

### [Supplementary note 11]

The device according to supplementary note 10, wherein the device is a communication infrastructure device.

As above, the present invention has been described taking the example embodiments mentioned above as an exemplary example. However, the present invention is not limited to the example embodiments mentioned above. In other words, various aspects which a person skilled in the art can understand can be applied to the present invention within the scope of the present invention.

This application is based upon and claims the benefit of priority from Japanese patent application No. 2015-89271, filed on April 24, 2015, the disclosure of which is incorporated herein in its entirety by reference.

### [Reference Signs List]

- 1: Communication infrastructure device
- 2: Inner device
- 3: Chassis element
- 4: Heat dissipation element (chassis element).
- 5: Brush
- 6: Heat dissipation grease
- 21: Substrate
- 22: Heat generating component
- 31: Low friction film
- 32: Heat conductive film

## Claims

1. A heat dissipation mechanism comprising:
a heat dissipation element for releasing heat outside, wherein
a heat generating element that generates heat and the heat dissipation element are thermally in contact with a heat conductive film composed of a thermally conductive material having fluid property with a low-friction film having a friction coefficient lower than a friction coefficient of the heat dissipation element or the heat generating element therebetween.

2. The heat dissipation mechanism according to Claim 1, wherein the low-friction film is composed of a dried-film lubricant.

3. The heat dissipation mechanism according to Claim 2, wherein the low-friction film does not have oil content.

4. The heat dissipation mechanism according to any one of Claims 1 to 3, wherein the low-friction film is composed of a fluorine-based lubricant.

5. The heat dissipation mechanism according to any one of Claims 1 to 4, wherein the thermally conductive material has hardenability.

6. The heat dissipation mechanism according to Claim 5, wherein the thermally conductive material is a two-component composition.

7. The heat dissipation mechanism according to any one of Claims 1 to 6, wherein the thermally conductive material is a silicon-based grease.

8. The heat dissipation mechanism according to any one of Claims 1 to 7,
wherein the heat conductive film is physically in contact with the heat generating element, and
wherein the low-friction film is physically in contact with the heat conductive film and the heat dissipation element, and has a friction coefficient lower than a friction coefficient of the heat dissipation element.

9. The heat dissipation mechanism according to any one of Claims 1 to 7,
wherein the heat conductive film is physically in contact with the heat dissipation element, and
wherein the low-friction film is physically in contact with the heat conductive film and the heat generating element, and has a friction coefficient lower than a friction coefficient of the heat generating element.

10. A device comprising:
a heat generating element that generates heat; and
a heat dissipation mechanism according to any one of Claims 1 to 9.
